# EUROPEAN PATENT SPECIFICATION

(11) **EP 1 324 382 B1**
(45) Date of publication and mention of the grant of the patent: **07.03.2007**
(21) Application number: 01830820.5
(22) Date of filing: 28.12.2001
(51) Int. Cl.: H01L 21/762

(54) **Process for manufacturing an SOI wafer by annealing and oxidation of buried channels**
Herstellungsverfahren für SOI Scheibe durch Wärmebehandlung und Oxidation von vergrabenen Kanälen
Procédé de fabrication d'un substrat SOI par recuit et oxydation de canals enterrés

(43) Date of publication of application: 02.07.2003
(73) Proprietor: STMicroelectronics S.r.l., 20041 Agrate Brianza (Milano) (IT)
(72) Inventor: Villa, Flavio, 20159 Milano (IT); Barlocchi, Gabriele, 20010 Cornaredo (IT); Corona, Pietro, 00185 Roma (IT)
(74) Representative: Cerbaro, Elena

(56) References cited:
- EP-A- 0 996 145
- EP-A- 1 043 770
- EP-A- 1 073 112
- TSUNASHIMA Y ET AL: "A new substrate engineering technique to realize silicon on nothing (SON) structure utilizing transformation of sub-micron trenches to empty space in silicon (ESS) by surface migration" HIGH PURITY SILICON VI. PROCEEDINGS OF THE SIXTH INTERNATIONAL SYMPOSIUM (ELECTROCHEMICAL SOCIETY PROCEEDINGS VOL. 2000-17) (SPIE VOL.4218), HIGH PURITY SILICON VI. PROCEEDINGS OF THE SIXTH INTERNATIONAL SYMPOSIUM, PHOENIX, AZ, USA, 22-27 OCT. 2000, pages 532-545, XP008004134 2000, Pennington, NJ, USA, Electrochem. Soc, USA ISBN: 1-56677-284-2
- PATENT ABSTRACTS OF JAPAN vol. 009, no. 212 (E-339), 29 August 1985 (1985-08-29) & JP 60 074452 A (MATSUSHITA DENKI SANGYO KK), 26 April 1985 (1985-04-26)
- SATO T ET AL: "MICRO-STRUCTURE TRANSFORMATION OF SILICON: A NEWLY DEVELOPED TRANSFORMATION TECHNOLOGY FOR PATTERNING SILICON SURFACES USING THE SURFACE MIGRATION OF SILICON ATOMS BY HYDROGEN ANNEALING" JAPANESE JOURNAL OF APPLIED PHYSICS, PUBLICATION OFFICE JAPANESE JOURNAL OF APPLIED PHYSICS. TOKYO, JP, vol. 39, no. 9A, PART 1, September 2000 (2000-09), pages 5033-5038, XP000977143 ISSN: 0021-4922

## Description

The present invention relates to a process for manufacturing an SOI wafer by annealing and oxidation of buried channels.

As is known, according to a solution that is currently very widespread in the sector of the microelectronics industry, the substrate of integrated devices is obtained from monocrystalline silicon wafers. In recent years, as an alternative to wafers made of silicon alone, composite wafers have been proposed, namely the so called silicon-on-insulator (SOI) wafers, consisting of two silicon layers, one of which is thinner than the other, separated by a silicon dioxide layer.

However, manufacturing of SOI wafers entails some problems, especially as regards the complexity and cost of the process and the quality of the thinner silicon layer. In fact, this layer is designed to house both high-power and low-power electronic devices, and the presence of crystallographic defects may irreparably impair the efficiency of the devices.

One method for manufacturing SOI wafers that partially tackles the above problems is described in EP-A 1 073 112, filed on 26 July 1999 in the name of the present applicant.

This method envisages initially forming, in a substrate of semiconductor material, for example monocrystalline silicon, a plurality of trenches which are substantially parallel and are separated from one another by silicon partition walls. In order to open the trenches, the substrate is anisotropically etched using a hard mask, which comprises, for example, a pad oxide layer and a silicon nitride layer.

Subsequently, by isotropically etching silicon, the trenches are widened so as to thin out the partition walls and form cavities which extend beneath the surface of the substrate, which, at this stage, is still protected by the hard mask.

The cavities are then lined with an inhibiting silicon dioxide layer, and the hard mask is removed, thus leaving the surface of the substrate uncovered.

Next, an epitaxial growth is carried out. In this step, the silicon grows on top of the substrate and expands laterally so as to form a uniform epitaxial layer that covers the entrance of the cavities. However, the inhibiting layer prevents silicon from growing inside the cavities, which thus are not filled and form buried channels.

Using a second anisotropic etch, connection trenches are opened, which have a depth such as to reach the cavities. Through the connection trenches, a thermal oxidation step is then performed, so that the partition walls separating the cavities are completely oxidized and the cavities are filled with silicon dioxide. Thereby, a continuous insulating region is formed, which separates the substrate and the epitaxial layer.

The process taught in the above mentioned patent application yields high quality SOI wafers, above all as regards crystallographic properties of the epitaxial layer, but has some limitations.

In fact, the processing steps required for forming the insulating region are numerous and complex and render the manufacturing of the wafers costly. First, during isotropic etching for widening the trenches and forming the cavities, the surface of the substrate must be protected, in particular with the hard mask. The formation of this mask, however, requires at least one oxidation step, one silicon nitride layer deposition step, and one definition step using a further resist mask. The hard mask must moreover be removed through further special steps.

Second, before carrying out the epitaxial growth, the cavities must be lined with the inhibiting layer; otherwise, in fact, the partition walls would get thicker and subsequently could no longer be oxidized completely. In addition, it is necessary to calibrate with precision the width of the inhibiting layer, which is partially removed during removal of the hard mask.

An example of a process for making silicon on nothing (SON) structures by converting sub-micron trenches into empty spaces in silicon is described in Tsunashima Y et al.: A new substrate engineering technique to realize silicon on nothing (SON) structure utilizing transformation of sub-micron trenches to empty space in silicon (ESS) by surface migration" HIGH PURITY SILICON VI. PROCEEDINGS OF THE SIXTH INTERNATIONAL SYMPOSIUM (ELECTROCHEMICAL SOCIETY PROCEEDINGS VOL. 2000-17)(SPIE VOL. 4218), PHOENIX, AZ, USA, 22-27 OCT 2000, pages 532-545.

The aim of the present invention is therefore to overcome the drawbacks of the manufacturing process described above.

According to the present invention, a process is provided for manufacturing SOI wafers by annealing and oxidation of buried channels, as defined in claim 1.

For a better understanding of the present invention, a preferred embodiment thereof is now described, purely as a non-limiting example, with reference to the attached drawings, wherein:
- Figures 1-4 are cross-sectional views of a wafer of semiconductor material in successive manufacturing steps, according to an embodiment of the present invention;
- Figure 5 is a top plan view of the wafer of Figure 4;
- Figure 6 is a cross-sectional view of the wafer of Figure 5 according to line VI-VI;
- Figures 7-10 are a cross-sectional views of the wafer of Figure 5 according to line VII-VII, in successive manufacturing steps;
- Figure 11 is a top plan view of a wafer of semiconductor material in an initial manufacturing step according to a different embodiment of the invention;
- Figures 12 and 13 are cross-sectional views of the wafer of Figure 11 according to lines XII-XII and XIII-XIII, respectively; and
- Figure 14 presents the same view as in Figure 12 in a subsequent manufacturing step of the wafer.

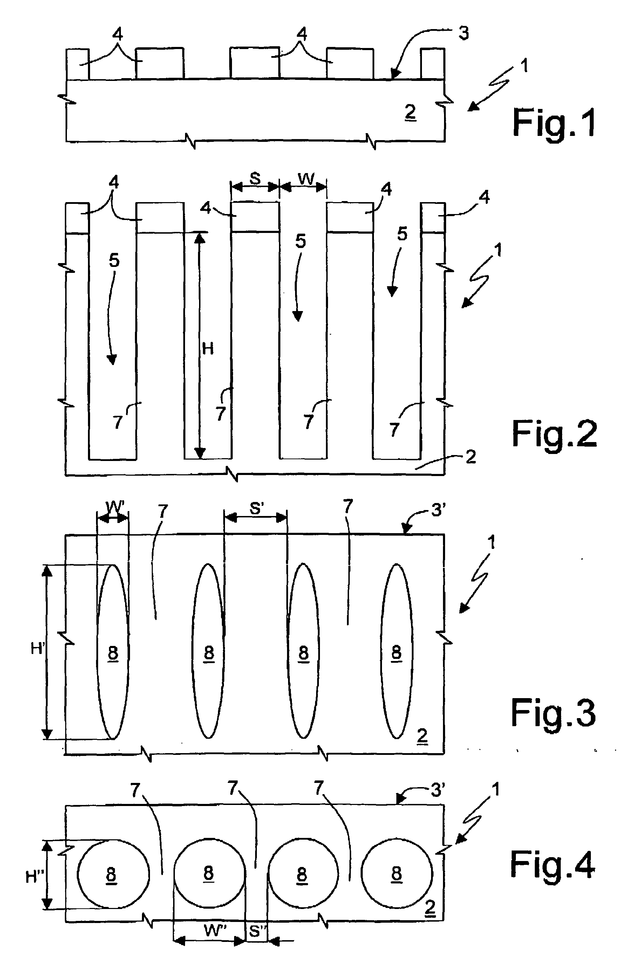

In Figure 1, a wafer of semiconductor material, for example monocrystalline silicon, is designated by 1 and comprises a substrate 2. In an initial step of the process according to the invention, a resist layer is deposited directly on top of a face 3 of wafer 1 and is defined to form a mask 4.

Next, the substrate 2 is etched anisotropically, for example through an STS etch, and deep trenches 5 are opened at the regions left uncovered by the mask 4, as shown in Figure 2. In greater detail, the deep trenches 5 are substantially rectilinear and extend parallel to each other in a direction perpendicular to the drawing plane. All the deep trenches 5 have a initial height H and a same initial width W, and are separated from one another by a wall 7 having an initial width S. The initial width W of the deep trenches 5 is substantially equal to the initial width S of the walls 7 (for example, 1 µm), while the initial depth H is much greater; preferably the ratio between the initial depth H and the initial width W is not smaller than 5.

Next, mask 4 is removed, and an epitaxial growth is performed (Figure 3). The silicon grows by a controlled amount on top of the face 3 of the wafer 1 and expands laterally until it closes the entrances of the deep trenches 5, thus practically forming buried channels 8 embedded in the wafer 1 and completely surrounded by silicon. In an initial stage of the epitaxial growth, silicon grows also inside the deep trenches 5, before the latter are closed at the top. Consequently, the buried channels 8 have cross sections that are substantially oval and elongated in a direction perpendicular to the surface 3' of the wafer 1. In particular, the buried channels 8 have an intermediate width W' and an intermediate height H', which are respectively smaller than the initial width W and the initial height S of the deep trenches 5. The intermediate width S' of the walls 7 is instead increased with respect to the initial width S (for example, the buried channels 8 have an intermediate width W' of 0.5 µm and an intermediate height H' of 3 µm, and the partition walls 7 have an intermediate width S' of 1.5 µm). In addition, the buried channels 8 house the same atmosphere in which the wafer 1 is immersed when the epitaxial growth is performed. In particular, this atmosphere has a high hydrogen concentration and is deoxidizing.

As shown in Figure 4, the cross section of the buried channels 8 is subsequently modified by a thermal annealing process having a controlled duration. For example, the wafer 1 is heated to 1150°C for 5 hours. In this step there is no removal of silicon. In practice, when the wafer 1 is heated in a deoxidizing atmosphere, the superficial silicon atoms around the buried channels 8 migrate and tend to assume minimum energy distributions, as explained in the article "A New Substrate Engineering for the Formation of Empty Space in Silicon (ESS) Induced by Silicon Surface Migration" by T. Sato, N. Aoki, I. Mizushima, and Y. Tsunashima, IEDM 1999, pp. 517-520. In greater detail, the buried channels 8, which initially have an oval cross section, tend to assume a substantially circular cross section. At the end of the annealing step, then, the buried channels 8 have a final height H" and a final width W" which are approximately equal to one another (for example, 1.5 µm), and the partition walls 7 are thinned out to reach a final width S" smaller than the initial width S (for example, 0.5 µm).

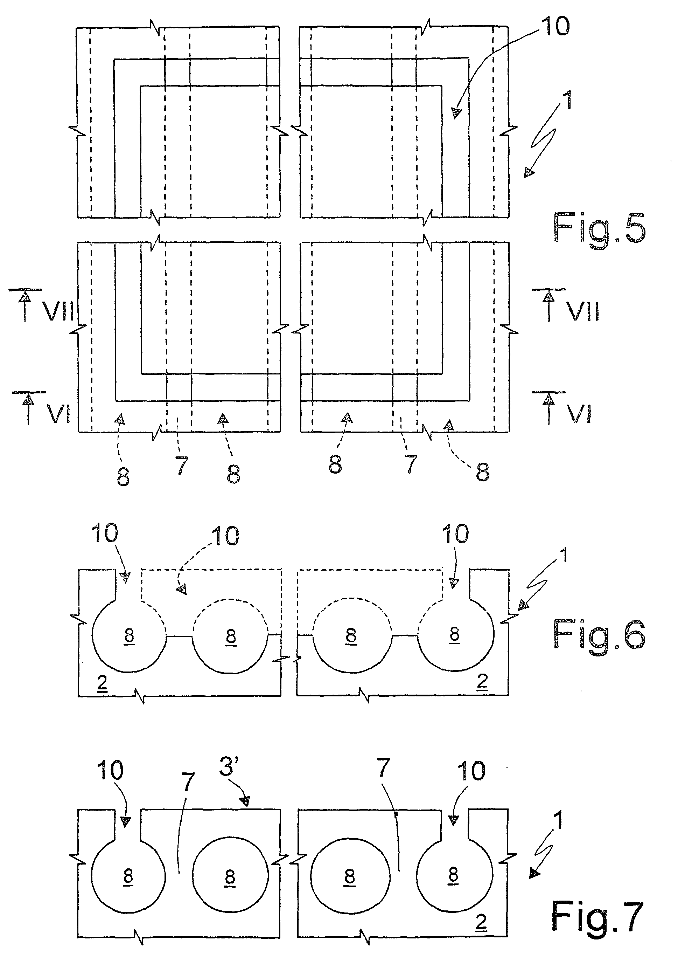

After annealing, a second masked trench etching is performed to open in the wafer 1 at least one connection trench 10 having a depth such as to reach all the buried channels 8 and a width greater than the final width S" of the partition walls 7 (for example, 1 µm). Preferably, the connection trench 10 extends along a closed line and delimits an insulated monocrystalline silicon region 11, intended to subsequently form an active area for accommodating integrated components (Figures 5-7).

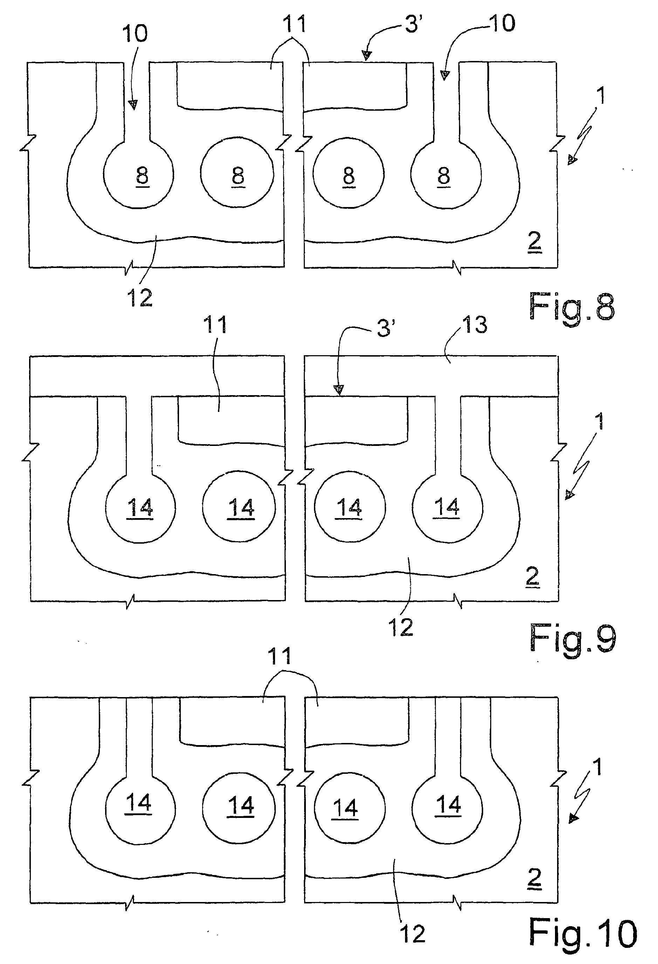

Next, thermal oxidation of the partition walls 7 and of the walls of the connection trench 10 is carried out so as to form a silicon dioxide insulating region 12. The oxygen required is fed to the buried channels 8 through the connection trench 10. In this step, the oxide regions gradually grow at the expense of the silicon regions that form the partition walls 7 and the walls of the connection trench 10. In particular, the partition walls 7 are completely oxidized, by virtue of the width reduction caused by the previous annealing step. As shown in Figure 8, the insulating region 12 surrounds the insulated region 11 laterally and at the bottom, electrically insulating it from the substrate 2. Instead, the buried channels 8 and the connection trench 10 are partly filled with thermal oxide, but remain partially open.

Next (Figure 9), on the surface 3' of the wafer 1 there is deposited a layer 13 of dielectric material, for example tetraethylorthosilicate (TEOS) oxide, which penetrates through the connection trench 10 and fills the buried channels 8 and the connection trench 10, preferably completely. In practice, the deposited dielectric material forms a filling area 14 within the insulating region 12. Consequently, the insulating region 12 and the filling region 14 form an insulating structure which is compact and substantially without any cavities inside it. However, regions of very small diameter may remain unfilled, but do not significantly alter the properties of the insulating structure. In particular, in addition to electrical insulation, the substantial continuity of the insulating region 12 and of the filling region 14 ensure thermal conductivity between the insulated region 11 and the substrate 2, and thus dispersion of the heat generated in the devices made in the wafer 1. The layer 13 of dielectric material is then removed.

The wafer 1 of Figure 10 is thus obtained, wherein the SOI-type structure can be clearly recognized. In particular, Figure 8 shows the insulated region 11 and the substrate 2 separated from one another by the insulating region 12 and the filling region 14. The substrate 2, which has a larger width, mainly performs the functions of support and heat dissipation, while inside the insulated region 11, which is thin, it is possible to form active and passive integrated devices according to any known process.

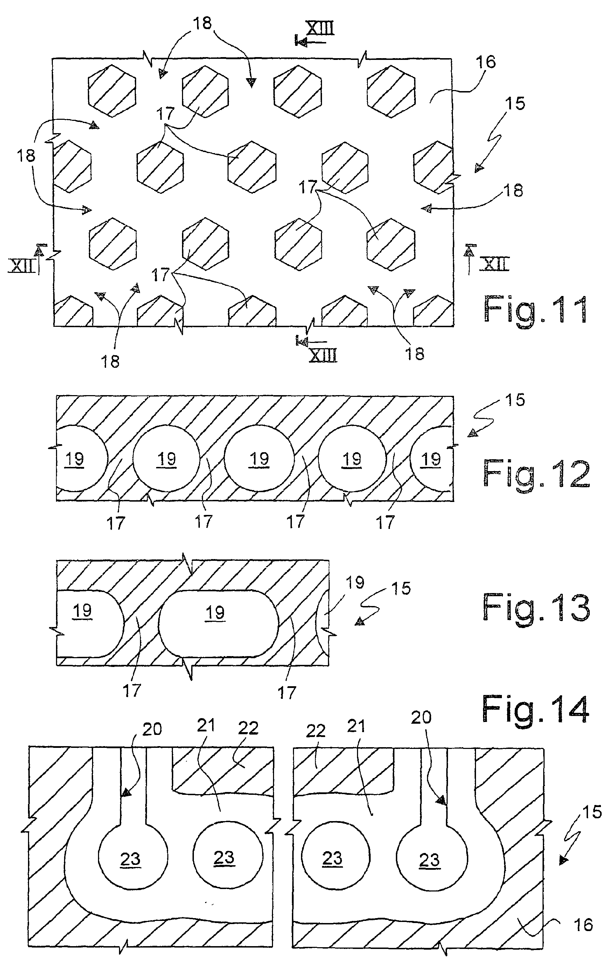

According to a different embodiment of the invention, shown in Figures 11-14, silicon columns 17 are initially formed in a substrate 16 of a semiconductor wafer 15, the silicon columns 17 preferably having a hexagonal shape in plan view and being organized in honeycomb fashion to obtain maximum packing. To this aim, silicon is selectively removed by trench etching, and communicating trenches 18 are formed, which delimit the columns 17. In practice, the communicating trenches 18 are connected together so as to form a hollow region having a complex shape, in which the columns 17 extend.

Next, epitaxial growth and annealing are carried out, as above described. In particular, during the epitaxial growth, the deep trenches 18 are closed, and a deep cavity 19 is formed, while during annealing, the columns 17 are thinned out in a central portion, thus assuming an hourglass shape (Figure 13).

The process is then completed as previously described. In particular, a connection trench 20 is opened, the columns 17 are completely oxidized so as to form an insulating region 21 which delimits an insulated silicon region 22, and the buried cavity 19 is filled with TEOS oxide, thus forming filling regions 23.

The process described herein is extremely simple, at the same time it enables manufacturing of SOI wafers that are free from crystallographic defects. In fact, the required processing steps are not so numerous as in known processes and can be easily included in standard processes for manufacturing integrated devices.

Particularly advantageous is the use of the annealing step, which, according to the invention, is performed instead of isotropic etching previously used for widening the trenches. The formation of structures, such as walls or columns, delimited by cavities and embedded in the silicon is in itself simple, in so far as it requires only one masked trench etch and one epitaxial growth. The subsequent annealing step allows the surfaces of the buried cavities (buried channels 8 and buried cavity 19) to be modified, widening the latter and reducing the width of the silicon structures (partition walls 7 and columns 17), so that the silicon structures can then be oxidized. The surface of the wafer is not, however, involved and thus does not have to be protected; consequently, all the steps for forming and removing hard masks are eliminated. Also the need for the inhibiting layer is overcome: since the annealing follows epitaxial growth, forming silicon inside the deep trenches 5 (or the communicating trenches 18) is within bearable limits, provided that these deep trenches are not filled completely.

In addition, the atmosphere entrapped inside the buried cavities is the same as used for the epitaxial growth, namely an atmosphere with a high hydrogen concentration. In practice, the annealing step, which normally requires the use of a hydrogen oven, can be performed using a standard thermal process. The more, with a single thermal process it is possible to carry out both annealing and other manufacturing steps that are normally envisaged for manufacturing components and/or integrated circuits; for example, annealing could be carried out simultaneously with the diffusion of a previously implanted doping species.

Finally, it is clear that numerous modifications and variations may be made to the process described and illustrated herein, all falling within the scope of the invention, as defined in the attached claims.

In particular, the process can be used for selectively insulating portions of the wafer. Alternatively, the insulating region may extend throughout the wafer.

Annealing could be carried out even before epitaxial growth. In this case, however, it would be necessary to use a hydrogen oven.

Furthermore, the initial shape of the trenches may be different from the shapes shown herein.

## Claims

1. A process for manufacturing an SOI wafer (1), comprising the steps of:
- trench etching a wafer (1) of semiconductor material, for forming in said wafer (1) of semiconductor material, cavities (8; 19) which delimit structures (7; 17) of said semiconductor material; and
- thermally oxidizing completely said structures (7; 17) wherein said thermally oxidizing includes feeding oxygen to said cavities;
**characterized by** performing, before said step of oxidizing, a step of thinning out said structures (7; 17) through a thermal process, wherein said thermal process comprises modifying the surface distribution of said semiconductor material around said cavities (8; 18) by annealing said wafer (1) in a deoxidizing atmosphere.

2. The process according to any one of the foregoing claims, **characterized in that** said thermal process has a controlled duration.

3. The process according to any one of the foregoing claims, **characterized in that** said step of forming cavities comprises burying said cavities (8; 18) within said wafer (1; 15).

4. The process according to claim 3, **characterized in that** said step of burying comprises entrapping hydrogen inside said cavities (8; 16).

5. The process according to any of the foregoing claims, **characterized in that** said step of forming cavities comprises the steps of:,
- opening first trenches (5; 18) in a substrate (2; 16) of said wafer (1; 15); and
- performing an epitaxial growth, so as to upwardly close said first trenches (5; 18) with said semiconductor material.

6. The process according to claim 5, **characterized in that** said structures comprise walls (7) arranged side-by-side and separated from each other by said first trenches (5).

7. The process according to claim 6, **characterized in that** said first trenches (5) are substantially rectilinear and have a height (H) and a width (W) smaller than said height (H), and **in that** the ratio between said height (H) and said width (W) is not smaller than 5.

8. The process according to claim 6, **characterized in that** said width (W) is substantially equal to a width (S) of said walls.

9. The process according to any of claims 6-8, **characterized in that**, at the end of said step of thinning out, said cavities (8) have a substantially circular cross-section.

10. The process according to claim 5, **characterized in that** said structures comprise columns (17).

11. The process according to any of the foregoing claims, **characterized in that**, before said step of oxidizing, at least one second trench (10; 20) having a depth reaching said cavities (8; 18) is opened

12. The process according to claim 10, **characterized in that** said second trench (10; 20) extends along a closed line and delimits an insulated region (11; 22).

13. The process according to any of the foregoing claims, **characterized in** forming, inside said cavities (8; 18), a filling region (14; 23) of a dielectric material.

14. The process according to claim 13, **characterized in that** said dielectric material is TEOS oxide.

## Patentansprüche

1. Prozess zur Herstellung eines SOI-Wafers (1), mit den die folgenden Schritten:
Ätzen von Gräben eines Wafers (1) aus Halbleitermaterial zur Bildung von Ausnehmungen (8; 19) in dem Wafer (1) aus Halbleitermaterial, welche Strukturen (7; 17) des Halbleitermaterials abgrenzen; und
vollständiges thermisches Oxidieren der Strukturen (7; 17), wobei das thermische Oxidieren das Zuführen von Sauerstoff zu den Ausnehmungen beinhaltet; **gekennzeichnet durch** das Durchführen, vor dem Schritt des Oxidierens, eines Schrittes des Ausdünnens der Strukturen (7; 17) **durch** einen thermischen Prozess, wobei der thermische Prozess das Modifizieren der Oberflachenverteilung des Halbleitermaterials um die Ausnehmungejn (8; 18) herum **durch** Annealen bzw. Glühen des Wafers (1) in einer deoxidierenden Atmosphäre aufweist.

2. Prozess nach einem der vorausgehenden Ansprüche, **dadurch gekennzeichnet, dass** der thermische Prozess eine gesteuerte Dauer besitzt.

3. Prozess nach einem der vorausgehenden Ansprüche, **dadurch gekennzeichnet, dass** der Schritt des Bildens der Ausnehmungen das Vergraben der Ausnehmungen (8; 18) innerhalb des Wafers (1; 15) aufweist.

4. Prozess nach Anspruch 3, **dadurch gekennzeichnet, dass** der Schritt des Vergrabens das Einschließen von Wasserstoff innerhalb der Ausnehmungen (8; 18) aufweist.

5. Prozess nach einem der vorausgehenden Ansprüche, **dadurch gekennzeichnet, dass** der Schritt des Bildens von Ausnehmungen die folgenden Schritte aufweist:
- Öffnen der ersten Gräben (5; 18) in einem Substrat (2; 16) des Wafers (1; 15); und
- Durchführen eines epitaxialen Wachstumsprozess, um so in Aufwärtsrichtung die ersten Gräben (5; 18) mit dem Halbmaterial zu schließen.

6. Prozess nach Anspruch 5, **dadurch gekennzeichnet, dass** die Strukturen Wände (7) aufweisen, welche Seite an Seite und durch die ersten Gräben (5) getrennt voneinander angeordnet sind.

7. Prozess nach Anspruch 5, **dadurch gekennzeichnet, dass** die ersten Gräben (5) im Wesentlichen geradlinig sind und eine Höhe (H) und eine Breite (W) kleiner als die Höhe (H) besitzen, und **dadurch**, dass das Verhältnis zwischen der Höhe (H) und der Breite (W) nicht kleiner als 5 ist.

8. Prozess nach Anspruch 6, **dadurch gekennzeichnet dass** die Breite (W) im Wesentlichen gleich der Breite (S) der Wände ist.

9. Prozess nach einem der Ansprüche 6 bis 8, **dadurch gekennzeichnet, dass** am Ende des Schrittes des Ausdünnens die Ausnehmungen (8) einen im Wesentlichen krcisforrnigen Querschnitt besitzen.

10. Prozess nach Anspruch 5, **dadurch gekennzeichnet, dass** die Strukturen Spalten (17) aufweisen.

11. Prozess nach einem der vorausgehenden Ansprüche, **dadurch gekennzeichnet, dass** vor dem Schritt des Oxidierens wenigstens ein zweiter Graben (10; 20), welcher eine Tiefe besitzt, welche an die Ausnehmungen (8; 18) heranreicht, geöffnet wird.

12. Prozess nach Anspruch 10, **dadurch gekennzeichnet, dass** der zweite Graben (10; 20) sich entlang einer geschlossenen Linie erstreckt und einen isolierten Bereich (11; 22) abgrenzt.

13. Prozess nach einem der vorausgehenden Ansprüche, der durch das Bilden, innerhalb der Ausnehmungen (8; 18), eines Füllbereichs (14; 23) aus dielektrischem Material **gekennzeichnet** ist.

14. Prozess nach Anspruch 13, **dadurch gekennzeichnet, dass** das dielektrische Material TEOS-Oxid ist.

## Revendications

1. Procédé de fabrication d'une plaquette de SOI (1), comprenant les étapes qui consistent à :
- graver des tranchées dans une plaquette (1) de matériau semi-conducteur, pour former, dans ladite plaquette (1) de matériau semi-conducteur, des cavités (8 ; 19) qui délimitent des structures (7 ; 17) dudit matériau semi-conducteur ; et
- oxyder complètement lesdites structures (7 ; 17) à la chaleur, où ladite oxydation thermique comprend l'amenée d'oxygène jusqu'auxdites cavités ;
**caractérisé par** l'exécution, avant ladite étape d'oxydation, d'une étape d'amincissement desdites structures (7 ; 17) au moyen d'un procédé thermique, où ledit procédé thermique comprend la modification de la distribution de surface dudit matériau semi-conducteur autour desdites cavités (8 ; 18), par un recuit de ladite plaquette (1) dans une atmosphère désoxydante.

2. Procédé selon l'une quelconque des revendications précédentes, **caractérisé en ce que** ledit procédé thermique a une durée contrôlée.

3. Procédé selon l'une quelconque des revendications précédentes, **caractérisé en ce que** ladite étape de formation de cavités comprend l'enfouissement desdites cavités (8 ; 18) dans ladite plaquette (1 ; 15).

4. Procédé selon la revendication 3, **caractérisé en ce que** ladite étape d'enfouissement comprend le piégeage d'hydrogène à l'intérieur desdites cavités (8 ; 18).

5. Procédé selon l'une quelconque des revendications précédentes, **caractérisé en ce que** ladite étape de formation de cavités comprend les étapes consistant à :
- ouvrir des premières tranchées (5 ; 18) dans un substrat (2 ; 16) de ladite plaquette (1; 15) ; et
- réaliser une croissance épitaxiale, de façon à fermer en partie supérieure lesdites premières tranchées (5 ; 18) avec ledit matériau semi-conducteur.

6. Procédé selon la revendication 5, **caractérisé en ce que** lesdites structures comprennent des parois (7) disposées côte à côte et séparées les unes des autres par lesdites premières tranchées (5).

7. Procédé selon la revendication 6, **caractérisé en ce que** lesdites premières tranchées (5) sont essentiellement rectilignes et ont une hauteur (H) et une largeur (W) inférieure à ladite hauteur (H), et **en ce que** le rapport entre ladite hauteur (H) et ladite largeur (W) n'est pas inférieur à 5.

8. Procédé selon la revendication 6, **caractérisé en ce que** ladite largeur (W) est essentiellement égale à une largeur (S) desdites parois.

9. Procédé selon l'une quelconque des revendications 6 à 8, **caractérisé en ce que**, à la fin de ladite étape d'amincissement, lesdites cavités (8) ont une section transversale essentiellement circulaire.

10. Procédé selon la revendication 5, **caractérisé en ce que** lesdites structures comprennent des colonnes (17).

11. Procédé selon l'une quelconque des revendications précédentes, **caractérisé en ce que**, avant ladite étape d'oxydation, au moins une deuxième tranchée (10 ; 20) ayant une profondeur atteignant lesdites cavités (8 ; 18) est ouverte.

12. Procédé selon la revendication 10, **caractérisé en ce que** ladite deuxième tranchée (10 ; 20) s'étend le long d'une ligne fermée et délimite une région isolée (11 ; 22).

13. Procédé selon l'une quelconque des revendications précédentes, **caractérisé par** la formation, à l'intérieur desdites cavités (8 ; 18), d'une région de remplissage (14 ; 23) d'un matériau diélectrique.

14. Procédé selon la revendication 13, **caractérisé en ce que** ledit matériau diélectrique est de l'oxyde de TEOS.
